# EUROPEAN PATENT APPLICATION

(11) **EP 3 267 136 A1**
(43) Date of publication of application: **10.01.2018**
(21) Application number: 16758414.3
(22) Date of filing: 02.03.2016
(51) Int. Cl.: F28D 9/00, H02K 5/20

(54) **CYLINDRICAL MEMBER FOR COOLING AND HEATING**

(30) Priority: 03.03.2015 CN 201510093348
(71) Applicant: Liu, Jian, Ningbo city Zhejiang province 315151 (CN)
(72) Inventor: Liu, Jian, Ningbo city Zhejiang province 315151 (CN)
(74) Representative: Becker Kurig Straus
(86) International application number: PCT/CN2016/000104
(87) International publication number: WO 2016/138797

(57) **Abstract**

A cylinder member for cooling and heating, comprising a plate-like profile body which is bent around the axis to form a cylinder shape; the two end faces of the plate-like profile body are fixed by welding; the plate-like profile body is provided with a fluid channel group formed by a plurality of through-holes which are arranged in parallel along the axial direction; the fluid channel group is formed with a fluid channel group inlet and a fluid channel group outlet, such that the member improves the cooling effect, facilitates processing, reduces the processing cost and material cost; under the condition of the same wall thickness, enhances the rigidity of the whole component by pulling corresponding profiles and using a simple bent plate mold can finish the processing.

## Description

### Technical Field

The present invention relates to a cylindrical member, in particular to a cylinder member for cooling and heating.

### Description of Related Art

Existing cylindrical members are applied to cooling and heating occasions in many cases. For example, motor housings usually need cooling. Many containers which accommodate liquid need not only cooling, but also heating. At present, the main components include the following types: the first is made of profiles, but the pipes thereof usually can only be straight pipes, and the water pipe structure is complicated, high in cost and can affect the rigidity of housings, the second is an embedded pipe processing, wherein the cooling pipes are pre-embedded into thick walls, where such process is complicated in technology, and needs the use of molds with higher cost, the third is sleeve-connection processing, where the cooling pipes are disposed between two layers of housings, where such structure has poor rigidity and high cost.

### BRIEF SUMMARY OF THE INVENTION

The technical problem to be solved by the present invention is to provide a cylinder member for cooling and heating, which is to be conveniently processed, has low cost, high rigidity, and good cooling effects.

The technical solution adopted by the present invention to solve the technical problem is as follows, a cylinder member for cooling and heating includes a plate-like profile body which is bent around the axis to form a cylinder shape, the two end faces of the plate-like profile body are fixed by welding, the plate-like profile body is provided with a fluid channel group formed by a plurality of through-holes which are arranged in parallel along the axial direction, the fluid channel group is provided with a fluid channel group inlet and a fluid channel group outlet.

Each one of the through-holes is formed with a through-hole inlet and a through-hole outlet, the fluid channel group inlet is formed at one end of the plate-like profile body and communicates with all of the through-hole inlets, the fluid channel group outlet is formed at the other end of the plate-like profile body and communicates with all of the through-hole outlets.

The cross-section area of the fluid channel group inlet is equal to the sum of the cross-section areas of all of the through-hole inlets, the cross-section area of the fluid channel group outlet is equal to the sum of the cross-section areas of all of the through-hole outlets.

Each one of the through-holes is formed with a through-hole inlet and a through-hole outlet; the through-hole inlet and the through-hole outlet are respectively formed at the two end faces of the plate-like profile body, the through-hole inlets and through-hole outlets of the adjacent through-holes communicate with each other, the fluid channel group inlet is formed at the through-hole inlet of the first through-hole, the fluid channel group outlet is formed at the through-hole outlet of the last through-hole.

The through-hole inlet and the through-hole outlet of each one of the through-holes are mutually staggered; the through-hole inlets and the through-hole outlets of the adjacent through-holes are mutually aligned.

The fluid channel group inlet consists of two rows of through-hole inlets, the fluid channel group outlet consists of two rows of through-hole outlets, the through-hole inlets are formed on the outer surface of the plate-like profile body, the through-hole outlets are symmetrically formed on the outer surface of the plate-like profile body opposite to the through-hole inlet.

Compared with the prior art, the advantages of this utility model are: using a plate-like profile body bent around the axis to form a cylindrical shape, the two end faces of the plate-like profile body are fixed by welding, the plate-like profile body is provided with the fluid channel group formed by a plurality of through-holes which are arranged in parallel along the axial direction, the fluid channel group is provided with the fluid channel group inlet and the fluid channel group outlet, not only the cooling effect is greatly improved, but also the processing is greatly convenient, the processing cost and material cost are greatly reduced; meanwhile, compared with the prior art, under the condition of the same wall thickness, the rigidity of the whole member is also greatly enhanced, by pulling corresponding profiles, using a simple bent plate mold and welding on one face, the processing of the cylinder member of the present invention can be completed; the fluid channel group inlet communicates with all of the through-hole inlets, the fluid channel group outlet communicates with all of the through-hole outlets, can greatly increase the throughput of the cooling fluid, further effectively improving the cooling efficiency.

### BRIEF DESCRIPTION OF THE DRAWINGS

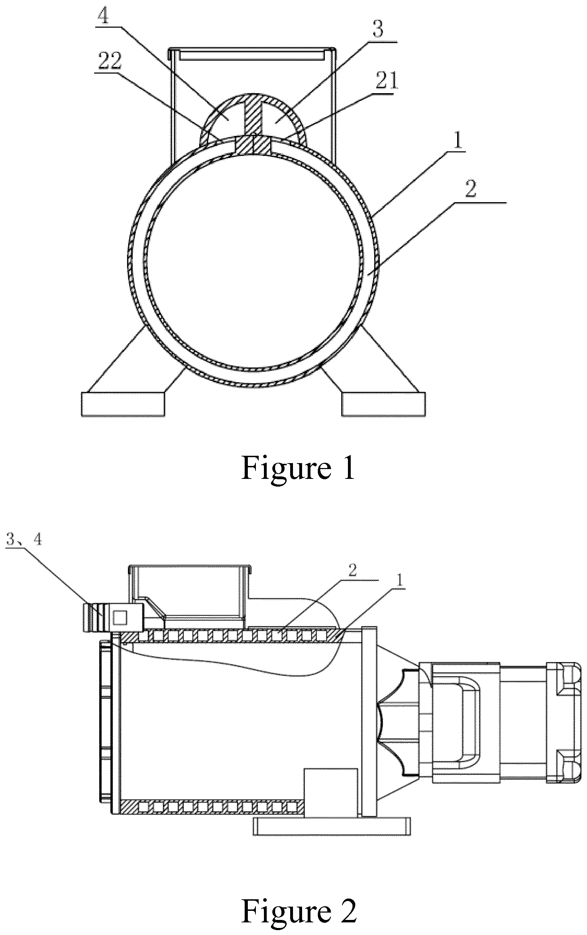

FIG.1 is a structural view 1 of embodiment 1 of the present invention;
FIG.2 is a structural view 2 of embodiment 1 of the present invention;

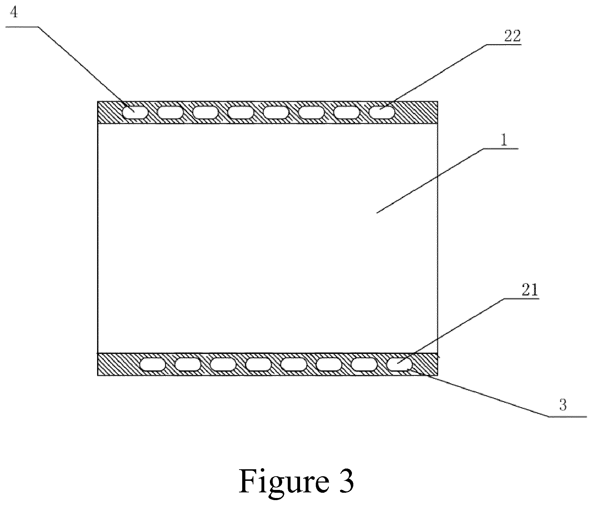

FIG.3 is a structural view 1 of embodiment 2 of the present invention;

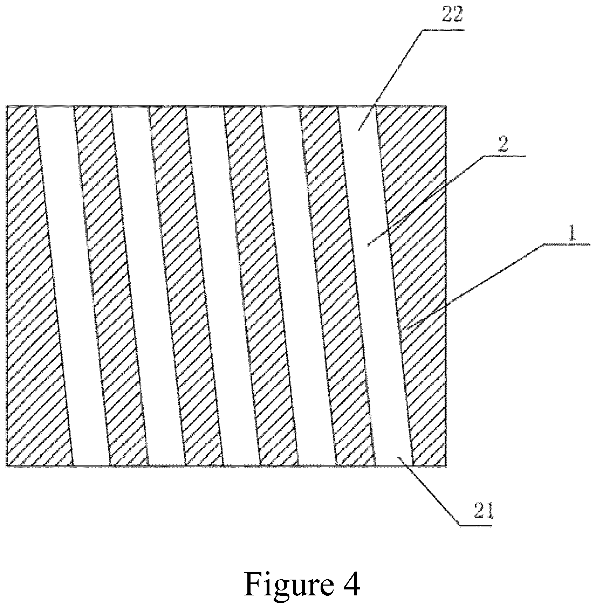

FIG.4 is a structural view 2 of embodiment 2 of the present invention;

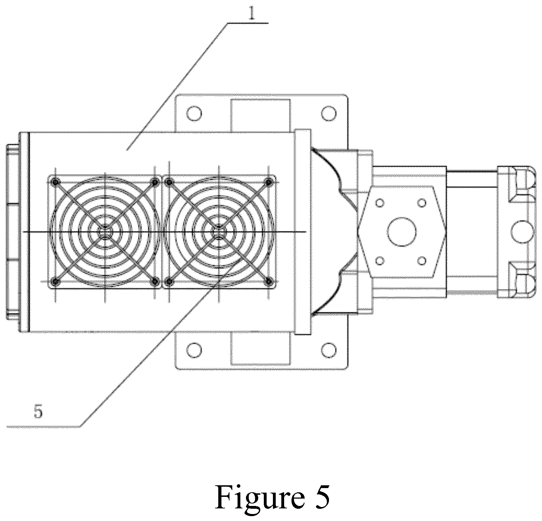

FIG.5 is a top view of embodiment 3 of the present invention;

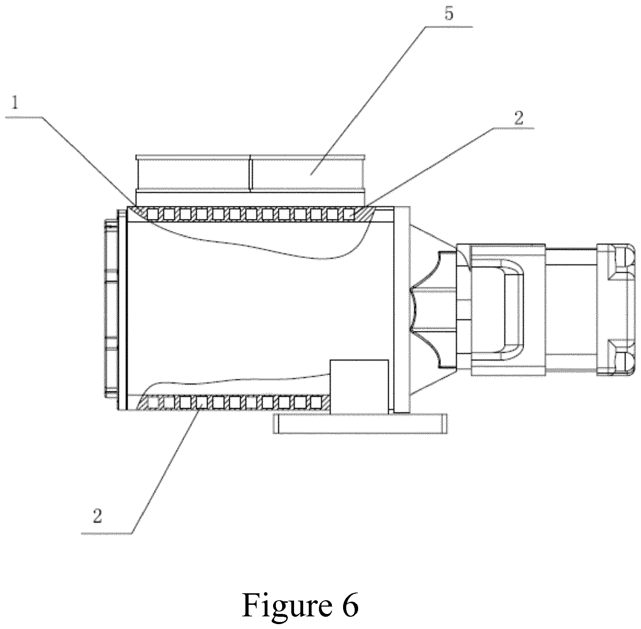

FIG.6 is a structural view of embodiment 3 of the present invention;

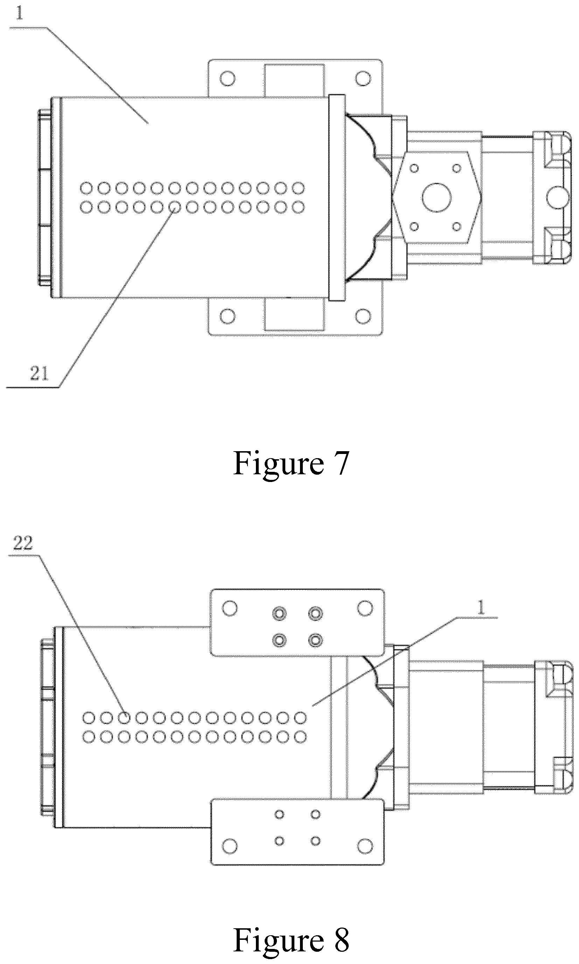

FIG.7 is a top view of embodiment 3 of the present invention, with a fan removed; and
FIG.8 is a bottom view of embodiment 3 of the present invention.

### DETAILED DESCRIPTION OF THE INVENTION

The present invention is described in further detail with reference to the attached drawings and embodiments.

Embodiment 1: A cylinder member for cooling and heating includes a plate-like profile body 1 which is bent around the axis to form a cylinder shape, the plate-like profile body 1 is provided with a fluid channel group formed by a plurality of through-holes 2 which are arranged in parallel along the axial direction, each one of the through-holes 2 is formed with a through-hole inlet 21 and a through-hole outlet 22, a fluid channel group inlet 3 is formed at one end of the plate-like profile body 1, a fluid channel group outlet 4 is formed at the other end of the plate-like profile body 1, the two end faces of the plate-like profile body 1 are fixed by welding, the fluid channel group inlet 3 communicates with all of the through-hole inlets 21, the fluid channel group outlet 4 communicates with all of the through-hole outlets 22, the cross-section area of the fluid channel group inlet 3 is equal to the sum of the cross-section areas of all of the through-hole inlets 21, the cross-section area of the fluid channel group outlet 4 is equal to the sum of the cross-section areas of all of the through-hole outlets 22.

Embodiment 2: A cylinder member for cooling and heating comprising a plate-like profile body 1 which is bent around the axis to form a cylinder shape, the plate-like profile body 1 is provided with a fluid channel group formed by a plurality of through-holes 2 which are arranged in parallel along the axial direction, each one of the through-holes 2 is formed with a through-hole inlet 21 and a through-hole outlet 22, the through-hole inlet 21 and the through-hole outlet 22 are respectively formed on the two end faces of the plate-like profile body 1, the through-hole inlet 21 and the through-hole outlet 22 of each one of the through-holes 2 are mutually staggered, the through-hole inlets 21 and the through-hole outlets 22 of the adjacent through-holes 2 are mutually aligned, the two end faces of the plate-like profile body 1 are fixed by welding, under such circumstances, the through-hole inlets 21 and the through-hole outlets 22of the adjacent through-holes 2 communicate with each other, thus forming fluid channels from the through-hole inlet 21 of the first through-hole 2 to the through-hole outlet 22 of the last through-hole 2, the fluid channel group inlet 3 is formed at the through-hole inlet 21 of the first through-hole 2, the fluid channel group outlet 4 is formed at the through-hole outlet 22 of the last through-hole 2.

Embodiment 3: A cylinder member for cooling and heating includes a plate-like profile body 1 which is bent around the axis to form a cylinder shape, the plate-like profile body 1 is provided with a fluid channel group formed by a plurality of through-holes 2 which are arranged in parallel along the axial direction, the two end faces of the plate-like profile body 1 are fixed by welding, so the through-holes 2 form a closed annular through-hole, in such circumstances, two rows of through-hole inlets 21 are formed on the outer surface of the plate-like profile body 1 to form the fluid channel group inlet, while two rows of through-hole outlets 22 are symmetrically formed on the outer surface of the plate-like profile body 1 opposite to the through-hole inlet 21, such structure is relatively suitable for air cooling, as long as a fan 5 is disposed outside the through-hole inlet 21, the cooling air can be blown in via the through-hole inlets 21 and blown out via the through-hole outlets 22.

## Claims

1. A cylinder member for cooling and heating, **characterized by** comprising a plate-like profile body which is bent around the axis to form a cylinder shape; the two end faces of the plate-like profile body are fixed by welding; the plate-like profile body is provided with a fluid channel group formed by a plurality of through-holes which are arranged in parallel along the axial direction; and the fluid channel group is provided with a fluid channel group inlet and a fluid channel group outlet.

2. The cylinder member for cooling and heating according to claim 1, **characterized in that** each one of the through-holes is formed with a through-hole inlet and a through-hole outlet; the fluid channel group inlet is formed at one end of the plate-like profile body and communicates with all of the through-hole inlets, and the fluid channel group outlet is formed at the other end of the plate-like profile body and communicates with all of the through-hole outlets.

3. The cylinder member for cooling and heating according to claim 2, **characterized in that** the cross-section area of the fluid channel group inlet is equal to the sum of the cross-section areas of all of the through-hole inlets, and the cross-section area of the fluid channel group outlet is equal to the sum of the cross-section areas of all of the through-hole outlets.

4. The cylinder member for cooling and heating according to claim 1, **characterized in that** each one of the through-holes is formed with a through-hole inlet and a through-hole outlet; the through-hole inlet and the through-hole outlet are respectively formed at two end faces of the plate-like profile body; the through-hole inlets and through-hole outlets of adjacent through-holes communicate with each other; the fluid channel group inlet is formed at the through-hole inlet of the first through-hole, and the fluid channel group outlet is formed at the through-hole outlet of the last through-hole.

5. The cylinder member for cooling and heating according to claim 4, **characterized in that** the through-hole inlet and the through-hole outlet of each one of the through-holes are mutually staggered; and the through-hole inlets and the through-hole outlets of adjacent through-holes are mutually aligned.

6. The cylinder member for cooling and heating according to claim 1, **characterized in that** the fluid channel group inlet consists of two rows of through-hole inlets; the fluid channel group outlet consists of two rows of through-hole outlets; the through-hole inlets are formed on the outer surface of the plate-like profile body; and the through-hole outlets are symmetrically formed on the outer surface of the plate-like profile body opposite to the through-hole inlet.
